# EUROPEAN PATENT APPLICATION

(11) **EP 4 044 169 A1**
(43) Date of publication of application: **17.08.2022**
(21) Application number: 21846073.1
(22) Date of filing: 08.06.2021
(51) Int. Cl.: G09G 3/3225, G09G 3/3266

(54) **DISPLAY SUBSTRATE AND DISPLAY DEVICE**

(30) Priority: 21.07.2020 CN 202010707527
(71) Applicant: BOE Technology Group Co., Ltd., Beijing 100015 (CN); Hefei Boe Joint Technology Co., Ltd., Xinzhan District Hefei Anhui 230012 (CN)
(72) Inventor: YUAN, Zhidong, Beijing 100176 (CN); LI, Yongqian, Beijing 100176 (CN); YUAN, Can, Beijing 100176 (CN); XU, Pan, Beijing 100176 (CN)
(74) Representative: Haseltine Lake Kempner LLP
(86) International application number: PCT/CN2021/099017
(87) International publication number: WO 2022/017032

(57) **Abstract**

Provided is a display substrate and a display device, and relates to the field of display technologies. In the display substrate, because at least two pixels disposed on the base substrate may share the same light emitting control circuit connected to the light emitting control lines, the number of light emitting control circuits required to be set in the display substrate may be reduced, or the number of light emitting control lines required to be set in the display substrate may be reduced. That is, the area, occupied by each pixel, of the base substrate is smaller. Therefore, both the gate drive circuit that provides the signal for the signal line connected to the pixel, and the drive signal connected to the gate drive circuit can be disposed on the base substrate. The display substrate provided in the present disclosure has a higher resolution.

## Description

### CROSS-REFERENCE TO RELATED APPLICATION

This application claims priority to Chinese Patent Application No. 202010707527.3, filed on July 21, 2020 and entitled "DISPLAY SUBSTRATE AND DISPLAY DEVICE," the disclosure of which is herein incorporated by reference in its entirety.

### TECHNICAL FIELD

The present disclosure relates to the field of display technologies, and in particular, relates to a display substrate and a display device.

### BACKGROUND

Organic light emitting diode (OLED) display substrates are widely used in the display field due to advantages such as self-luminescence, wide viewing angle, and fast response speed.

In the related art, an OLED display substrate includes a base substrate, and a plurality of pixels disposed on the base substrate. Each pixel includes a light emitting control circuit, a light emitting drive circuit, and a light emitting element. The light emitting control circuit can provide, in response to a light emitting control signal provided by the light emitting control line to which it is connected, a DC power signal to the light emitting drive circuit, and the light emitting drive circuit can provide, in response to a gate drive signal provided by a gate line to which it is connected and the received DC power signal, a light emitting drive signal to the light emitting element. Furthermore, light emitting control circuits connected to different pixels are different.

Because the light emitting control circuits connected to different pixels are different, a greater number of light emitting control lines are required in the display substrate. The greater number of light emitting control lines may occupy a larger area of the base substrate, which is not conducive to the implementation of high resolution.

### SUMMARY

Embodiments of the present disclosure provide a display substrate and a display device. The technical solutions are as follows.

In an aspect, a display substrate is provided. The display substrate includes:
a base substrate;
a plurality of pixels arranged in an array on the base substrate, wherein each of the pixels includes: a light emitting control circuit, a light emitting drive circuit, and a light emitting element, and at least two of the pixels share a same light emitting control circuit; and
a gate drive circuit, a plurality of light emitting control lines, a plurality of gate lines, and a plurality of drive signal lines that are disposed on the base substrate, wherein the gate drive circuit are connected to the plurality of drive signal lines, the plurality of light emitting control lines, and the plurality of gate lines, the plurality of light emitting control lines are connected to the light emitting control circuits in the plurality of pixels, the plurality of gate lines are connected to the light emitting drive circuits in the plurality of pixels, and the gate drive circuit is configured to output, in response to a drive signal provided by the plurality of drive signal lines, a light emitting control signal to the plurality of light emitting control lines, and a gate drive signal to the plurality of gate lines.

Optionally, the at least two of the pixels sharing the same light emitting control circuit are disposed in a same column

Optionally, the at least two of the pixels sharing the same light emitting control circuit are adjacent.

Optionally, each two of the pixels in the same column share a same light emitting control circuit.

Optionally, the two of the pixels sharing the same light emitting control circuit are symmetrically arranged on two sides of the light emitting control line connected to the light emitting control circuit.

Optionally, each of the drive signal lines is disposed between two adjacent columns of the pixels.

Optionally, at most two of the drive signal lines are disposed between each two adjacent columns of the pixels.

Optionally, the gate drive circuit includes: a plurality of cascaded shift register units,
wherein at least two of the plurality of cascaded shift register units are disposed between two adjacent rows of pixels.

Optionally, at least two of the plurality of cascaded shift register units are disposed between two adjacent rows of target pixels,
wherein in the two rows of target pixels, the light emitting control circuit connected to one row of target pixels is different from the light emitting control circuit connected to the other row of target pixels.

Optionally, two cascaded shift register units are disposed between each two adjacent rows of target pixels,
wherein one of the shift register units is connected to one row of target pixels, and the other of the shift register units is connected to the other row of target pixels.

Optionally, the two cascaded shift register units are symmetrically disposed between the two rows of target pixels.

Optionally, the shift register unit includes: an input sub-circuit, a pull-down control sub-circuit, a pull-down sub-circuit, and an output sub-circuit, wherein
the input sub-circuit is connected to a first input terminal, a second input terminal, a first control signal terminal, a second control signal terminal, and a pull-up node, and the input sub-circuit is configured to output, in response to a first input signal provided by the first input terminal, a first control signal provided by the first control signal terminal to the pull-up node, and output, in response to a second input signal provided by the second input terminal, a second control signal provided by the second control signal terminal to the pull-up node;
the pull-down control sub-circuit is connected to a first clock signal terminal, the pull-up node, a pull-down power terminal, a pull-down node, and an output terminal, and the pull-down control sub-circuit is configured to output, in response to a first clock signal provided by the first clock signal terminal, the first clock signal to the pull-down node, and output, in response to a potential of the pull-up node and an output signal provided by the output terminal, a pull-down power signal provided by the pull-down power terminal to the pull-down node;
the pull-down sub-circuit is connected to a reset signal terminal, the pull-down node, the pull-down power terminal, the pull-up node, and the output terminal, and the pull-down sub-circuit is configured to output, in response to a potential of the pull-down node, the pull-down power signal to the pull-up node and the output terminal, and output, in response to a reset signal provided by the reset signal terminal, the pull-down power signal to the pull-up node; and
the output sub-circuit is connected to the pull-up node, a second clock signal terminal, and the output terminal, and the output sub-circuit is configured to output, in response to the potential of the pull-up node, a second clock signal provided by the second clock signal terminal to the output terminal.

Optionally, the display substrate further includes: a plurality of data lines disposed on the base substrate;
the plurality of gate lines includes a plurality of first gate lines, a plurality of second gate lines, and a plurality of third gate lines; the light emitting control circuit includes a light emitting control transistor; and the light emitting drive circuit includes a data write transistor, a reset transistor, a drive transistor, a compensation transistor, and a storage capacitor,
wherein a gate of the data write transistor is connected to one of the first gate lines, a first electrode of the data write transistor is connected to a gate of the drive transistor, and a second electrode of the data write transistor is connected to one of the data lines; a first electrode of the drive transistor is connected to a first electrode of the light emitting control transistor, and a second electrode of the drive transistor is connected to the light emitting element; a gate of the light emitting control transistor is connected to one of the light emitting control lines, and a second electrode of the light emitting control transistor is connected to a DC power terminal; a gate of the reset transistor is connected to one of the second gate lines, a first electrode of the reset transistor is connected to a first initial signal terminal, and a second electrode of the reset transistor is connected to the second electrode of the drive transistor; a gate of the compensation transistor is connected to one of the third gate lines, a first electrode of the compensation transistor is connected to a second initial signal terminal, and a second electrode of the compensation transistor is connected to the gate of the drive transistor.

In another aspect, a display device is provided. The display device includes: a source drive circuit and the display substrate according to above aspect,
wherein the source drive circuit is connected to the plurality of data lines in the display substrate, and the source drive circuit is configured to provide a data signal for the data lines.

### BRIEF DESCRIPTION OF THE DRAWINGS

To describe the technical solutions in the embodiments of the present disclosure more clearly, the following briefly introduces the accompanying drawings required for describing the embodiments. Apparently, the accompanying drawings in the following description show merely some embodiments of the present disclosure, and persons of ordinary skill in the art can still derive other drawings from these accompanying drawings without creative efforts.
FIG. 1 is a schematic structural diagram of a display substrate according to an embodiment of the present disclosure;
FIG. 2 is a schematic structural diagram of another display substrate according to an embodiment of the present disclosure;
FIG. 3 is a schematic structural diagram of yet another display substrate according to an embodiment of the present disclosure;
FIG. 4 is a schematic structural diagram of a circuit of two adjacent pixels according to an embodiment of the present disclosure;
FIG. 5 is an optional structural layout of two adjacent pixels according to an embodiment of the present disclosure;
FIG. 6 is a schematic structural diagram of yet another display substrate according to an embodiment of the present disclosure;
FIG. 7 is a schematic structural diagram of yet another display substrate according to an embodiment of the present disclosure;
FIG. 8 is a schematic structural diagram of a schematic structural diagram of a shift register unit according to an embodiment of the present disclosure;
FIG. 11 is a schematic structural diagram of another shift register unit according to an embodiment of the present disclosure; and

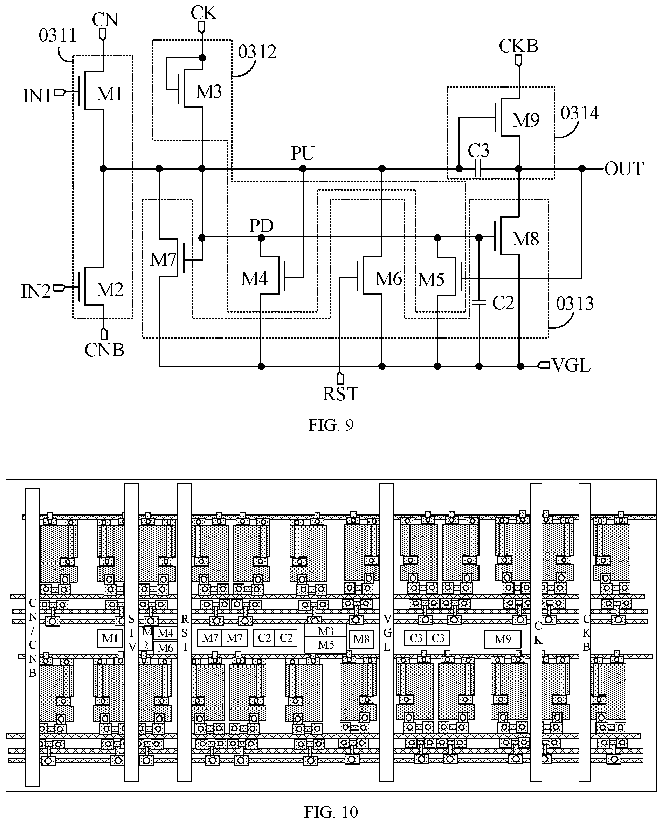

FIG. 10 is a schematic structural diagram of yet another display substrate according to an embodiment of the present disclosure;

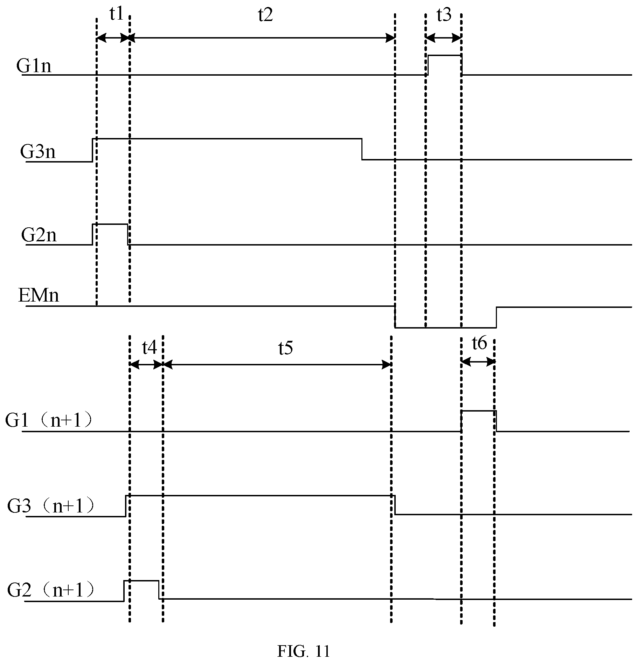

FIG. 11 is a timing diagram of an operation of a pixel according to an embodiment of the present disclosure; and

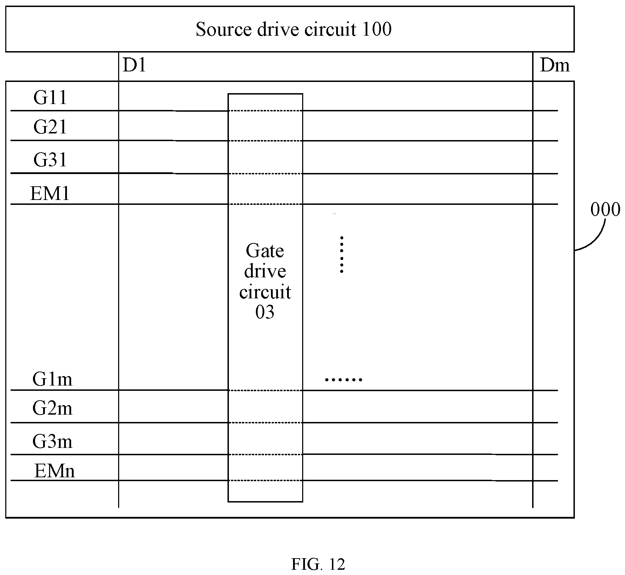

FIG. 12 is a schematic structural diagram of a display device according to an embodiment of the present disclosure.

### DETAILED DESCRIPTION

For clearer descriptions of the objectives, technical solutions, and advantages of inventive concepts of the embodiments of the present disclosure, the inventive concepts of the embodiments of the present disclosure are described in detail hereinafter with reference to the accompanying drawings and some embodiments.

The transistors in all embodiments of the present disclosure may be thin film transistors, field effect transistors, or other devices with similar properties, and the transistors in the embodiments of the present disclosure are primarily switch transistors according to the function of the transistors in a circuit. Because a source and a drain of the switch transistor herein are symmetrical, the source and the drain are interchangeable. In the embodiments of the present disclosure, the source is referred to as a first electrode, and the drain is referred to as a second electrode. Or, the drain is referred to as the first electrode, and the source is referred to as the second electrode. According to the form in the accompanying drawings, an intermediate terminal of the transistor is a gate, a signal input terminal is the source, and a signal output terminal is the drain. Furthermore, the switch transistor in the embodiments of the present disclosure may be either a P-type switch transistor or an N-type switch transistor. The P-type switch transistor is turned on in the case that the gate is at a low level, and is turned off in the case that the gate is at a high level. The N-type switch transistor is turned on in the case that the gate is at a high level, and is turned off in the case that the gate is at a low level.

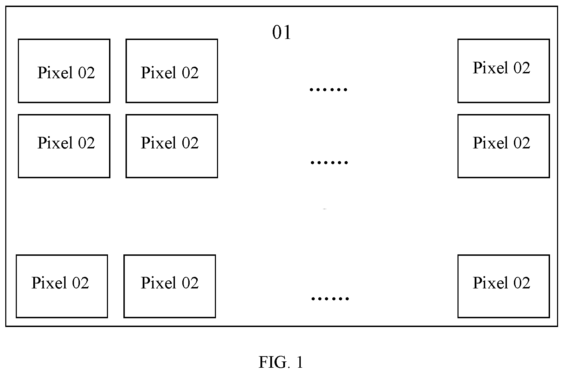

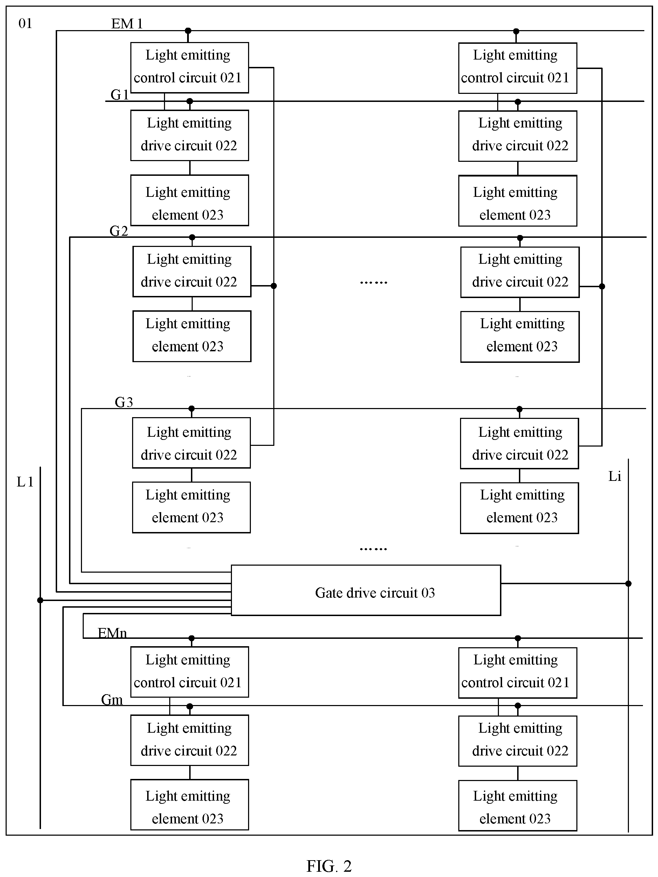

FIG. 1 is a schematic structural diagram of a display substrate according to an embodiment of the present disclosure. As shown in FIG. 1, the display substrate may include a base substrate 01, and a plurality of pixels 02 arranged in an array on the base substrate 01. 2 is a schematic structural diagram of another display substrate according to an embodiment of the present disclosure. It can be seen in combination with FIGS. 1 and 2 that, each pixel 02 may include a light emitting control circuit 021, a light emitting drive circuit 022, and a light emitting element 023, and at least two pixels 02 may share a same light control circuit 021. That is, at least two pixels 02 may operate under drive of the same light control circuit 021.

Referring to FIG. 2, it can be seen that the display substrate may further , a plurality of light emitting control lines (e.g., from EM1 to EMn shown in FIG. 2), a plurality of gate lines (e.g., from G1 to Gm shown in FIG. 2), and a plurality of drive signal lines (from L1 to Li shown in FIG. 2) that are disposed on the base substrate 01.

The gate drive circuit 03 may be connected to the plurality of drive signal lines, the plurality of light emitting control lines, and the plurality of gate lines. The plurality of light emitting control lines may be connected to the light emitting control circuits 021 in the pixels 02, and the plurality of gate lines may be connected to the light emitting drive circuits 022 in the pixels 02. The gate drive circuit 03 may be configured to output, in response to a drive signal provided by the plurality of drive signal lines, a light emitting control signal to the plurality of light emitting control lines, and a gate drive signal to the plurality of gate lines. That is, the gate drive circuit 03 may operate under drive of the drive signals provided by the plurality of drive signal lines.

Optionally, a plurality of rows of pixels 02 and the plurality of gate lines may generally be connected in one-to-one correspondence, and the plurality of rows of pixels 02 and the plurality of light emitting control lines may further be connected in one-to-one correspondence. That is, in the plurality of pixels 02 in the same row, the light emitting control circuits 021 in the pixels 02 may be connected to a same light emitting control line, and the light emitting drive circuits 022 in the pixels 02 may be connected to a same gate line. Accordingly, the number of the gate lines and the number of rows of pixels in the display substrate are the same in the embodiments of the present disclosure. Because at least two pixels 02 may share the same light emitting control circuit 021, the number of light emitting control circuits 021 required to be set may be reduced when the at least two pixels 02 are in the same row; and the number of light emitting control circuits 021 required to be set and the number of light emitting control lines required to be set may be reduced when the at least two pixels 02 are in the same column. As such, the effect of optimizing the pixel space is achieved without affecting the normal display of the pixels 02, that is, the area occupied by the pixels 02 on the base substrate 01 is reduced, compared to that in the related art. Therefore, the area of the remaining region of the base substrate 01 is increased, and the remaining region may be configured to reliably dispose the gate drive circuit 03 and the drive signal lines to be connected to the gate drive circuit 03. Thus, the display substrate with the gate drive circuit 03 disposed in the substrate is obtained, that is, a gate drive in array (GIA) display substrate is obtained.

In addition, with continuous reference to FIG. 2, it can be seen that, in each pixel 02, the light emitting control circuit 021 may further be connected to the light emitting drive circuit 022, and the light emitting drive circuit 022 may further be connected to the light emitting element 023. The light emitting control circuit 021 may be configured to output, in response to the light emitting control signal provided by the connected light emitting control line, a DC power signal to the connected light emitting drive circuit 022. The light emitting drive circuit 022 may be configured to output, in response to the gate drive signal provided by the connected gate line and the received DC power signal, the drive signal to the connected light emitting element 023 to drive the light emitting element 023 to emit light.

In summary, the embodiments of the present disclosure provide a display substrate. Because in the display substrate, the at least two pixels disposed on the base substrate may share the same light emitting control circuit connected to the light emitting control line, the number of light emitting control circuits required to be set in the display substrate may be reduced, or the number of light emitting control lines required to be set in the display substrate may be further reduced. That is, the area, occupied by each pixel, on the base substrate is smaller. Therefore, a gate drive circuit that provides a signal for a signal line connected to the pixel, and a drive signal connected to the gate drive circuit can be disposed on the base substrate. Thus, the display substrate provided in the embodiments of the present disclosure has a higher resolution.

Optionally, it can be seen in combination with FIG. 2 that, in the embodiment of the present disclosure, the at least two pixels 02 sharing the same light emitting control circuit 021 may be disposed in the same column. As such, in combination with the embodiment described above, compared to the related art, not only the number of the light emitting control circuits 021 required to be set on the base substrate 01 may be reduced, but also the number of the light emitting control lines required to be set on the base substrate 01 may be reduced.

For example, assuming that the display substrate includes m rows of pixels 02, in the case that at least two pixels 02 in the same column share the same light emitting control circuit 021, the number of the light emitting control lines disposed on the base substrate 01 is less than the number of rows of the pixels 02. That is, n is less than m in FIG. 2, and both m and n may be an integer greater than 1.

Optionally, the at least two pixels 02 sharing the same light emitting control circuit 021 not only are in the same column, bur also may be adjacent, which may be convenient for the layout and signal trace.

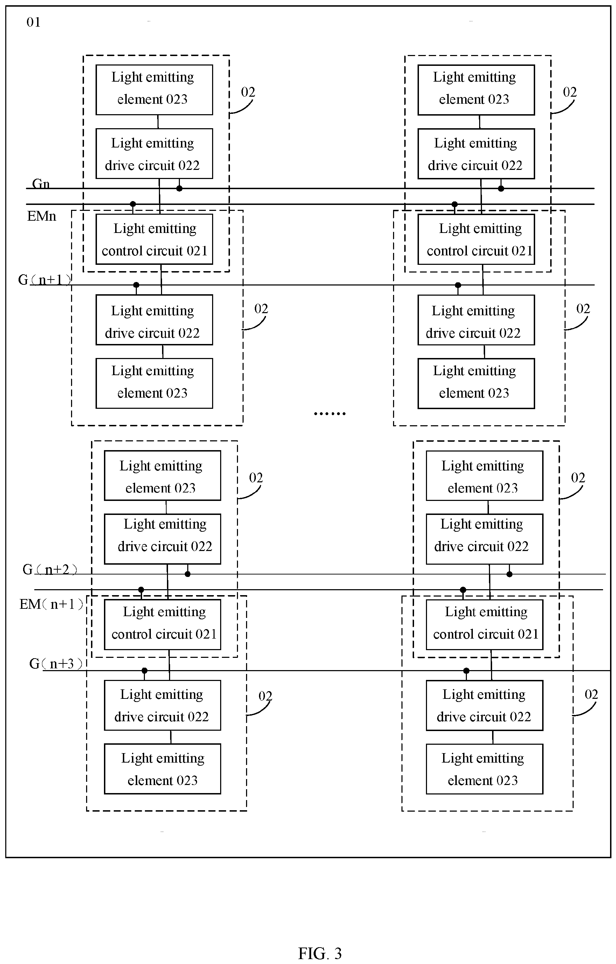

For example, FIG. 3 shows yet another display substrate by taking an example in which each two adjacent pixels 02 in the same column share the same light emitting control circuit 021. FIG. 3 schematically shows that the pixel 02 in the n^{th} row and the pixel 02 in the (n+1)^{th} row which are adjacent multiple the same light emitting control circuit 021, and the pixel 02 in the (n+2)^{th} row and the pixel 02 in the (n+3)^{th} row which are adjacent multiple the same light emitting control circuit 021. It can be further seen in combination with FIG. 3 that, adjacent two pixels 02 may also share the same light emitting control line (e.g., EMn and EM(n+1)) in the case that the two pixels 02 sharing the same light emitting control circuit 021 are in the same column.

Optionally, by taking an example in which the pixel 02 in the n^{th} row and the pixel 02 in the (n+1)^{th} row that are in the first column and are adjacent, and in conjunction with 3, 4 shows a diagram of an optional circuit of the two pixels 02, and 5 shows a layout of an optional circuit of the two pixels 02. Referring to FIGS. 3 to 5, in the embodiments of the present disclosure, the two pixels 02 sharing the same light emitting control circuit 021 may be symmetrically arranged on two sides of the light emitting control line EMn connected to the shared light emitting control circuit 021. That is, in the two pixels 02, transistors in one pixel 02 and connected signal lines, and transistors in the other pixel 02 and connected signal lines may be symmetrically disposed on two sides of the light emitting control line EMn. In such a design, not only the layout and the signal trace are convenient, but also the signal lines may be centralizedly disposed, thereby further optimizing the pixel space.

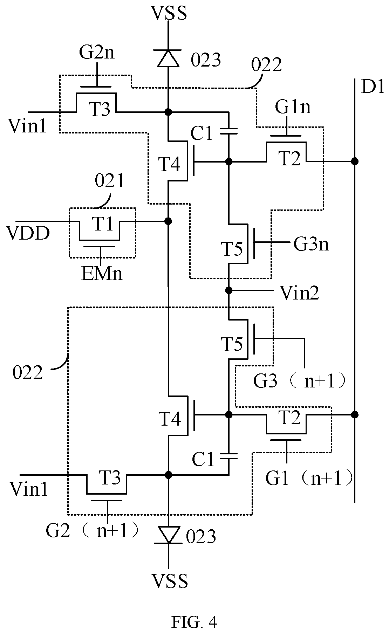

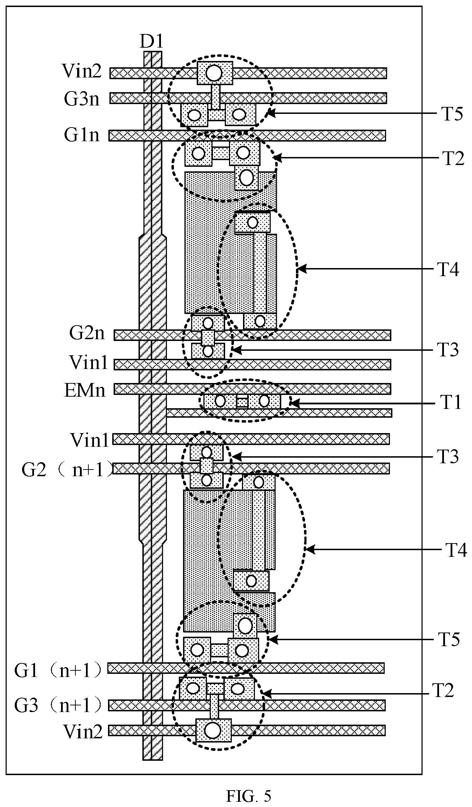

Referring to FIG. 4 and FIG. 5, in the embodiments of the present disclosure, to reliably drive the light emitting element 023 in the pixel 02 to emit light, the display substrate may further include a plurality of data lines disposed on the base substrate 01. The plurality of gate lines may include a plurality of first gate lines, a plurality of second gate lines, and a plurality of third gate lines.

The number of the data lines and the number of columns of the pixels may be same, the number of the first gate lines, the number of the second gate lines, and the number of the third gate lines may be equal to the number of rows of the pixels. FIG. 4 and FIG. 5 merely show one data line D1, two first gate lines G1n and G1(n+1), two second gate lines G2n and G2(n+1), and two third gate lines G3n and G3(n+1).

Reference to FIG. 4 and FIG. 5, in each pixel 02, the light emitting control circuit 021 may include a light emitting control transistor T1. The light emitting drive circuit 022 may include a data write transistor T2, a reset transistor T3, a drive transistor T4, a compensation transistor T5, and a storage capacitor C1.

A gate of the data write transistor T2 may be connected to one first gate line, a first electrode of the data write transistor T2 may be connected to a gate of the drive transistor T4, and a second electrode of the data write transistor T2 may be connected to one data line D1. The gate of the data write transistor T2 in the pixel 02 in the n^{th} row is connected to the first gate line G1n, and the gate of the data write transistor T2 in the pixel 02 in the (n+1)^{th} row is connected to the first gate line G1(n+1).

A first electrode of the drive transistor T4 may be connected to a first electrode of the light emitting control transistor T1, a second electrode of the drive transistor T4 may be connected to the light emitting element 023, and the light emitting element 023 may further be connected to a power terminal VSS.

A gate of the light emitting control transistor T1 may be connected to one light emitting control line EMn, and a second electrode of the light emitting control transistor T1 may be connected to a DC power terminal VDD.

A gate of the reset transistor T3 may be connected to one second gate line, a first electrode of the reset transistor T3 may be connected to a first initial signal terminal Vin1, and a second electrode of the reset transistor T3 may be connected to a second electrode of the drive transistor T4. The gate of the reset transistor T3 in the pixel 02 in the n^{th} row is connected to the second gate line G2n, and the gate of the reset transistor T3 in the pixel 02 in the (n+1)^{th} row is connected to the second gate line G2(n+1).

A gate of the compensation transistor T5 may be connected to one third gate line, a first electrode of the compensation transistor T5 may be connected to a second initial signal terminal Vin2, and a second electrode of the compensation transistor T5 may be connected to the gate of the drive transistor T4. The gate of the compensation transistor T5 in the pixel 02 in the n^{th} row is connected to the third gate line G3n, and the gate of the compensation transistor T5 in the pixel 02 in the (n+1)^{th} row is connected to the third gate line G3(n+1).

It is noted that the above is merely a schematic illustration of an optional structure of the pixel 02, which is a 5T1C (that is, five transistors and one capacitor) structure. The structure of the pixel 02 is not limited in the embodiments of the present disclosure, which may also be other structures, such as a 7T1C structure.

The following embodiments all illustrate an optional structure of the display substrate by taking an example in which each two adjacent pixels 02 in the same column share the same light emitting control circuit 021.

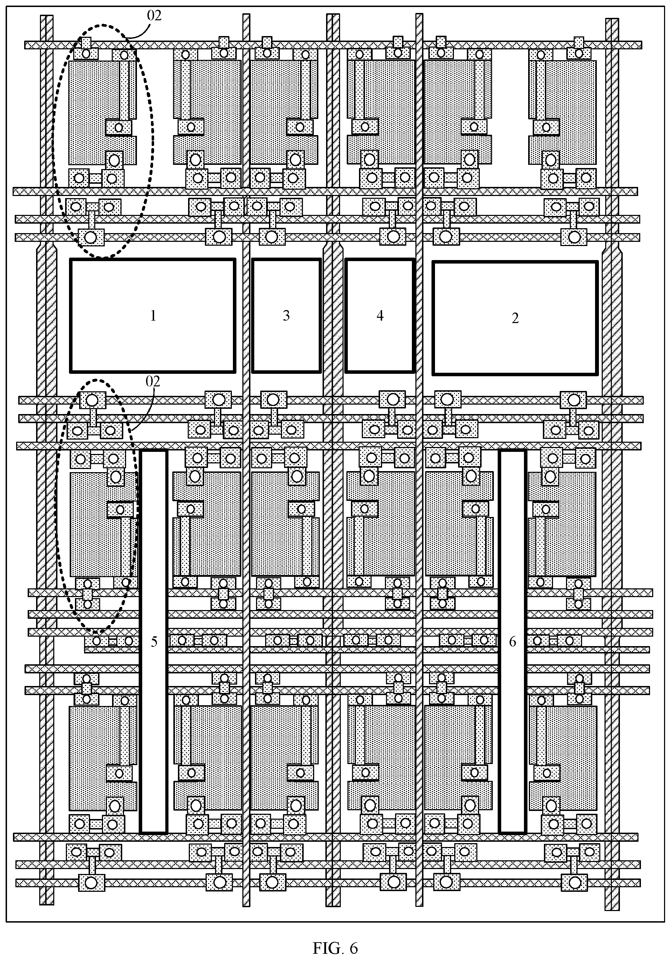

Optionally, in the embodiments of the present disclosure, the drive signal lines connected to the gate drive circuit 03 may each be disposed between two adjacent columns of pixels 02. For example, referring to FIG. 6, which shows yet another display substrate, because each two adjacent pixels 02 in the same column share the same light emitting control circuit 021, additional regions are reserved between each two adjacent columns of pixels 02, such as region 5 and region 6 shown in FIG. 6. Correspondingly, the drive signal lines connected to the gate drive circuit 03 may be disposed in the region 5 and region 6.

Optionally, as the region between each two adjacent columns of pixels 02 is limited, at most two drive signal lines may be disposed between each two adjacent columns of pixels 02 to ensure a reliable setting of the drive signal lines.

In the embodiments of the present disclosure, the gate drive circuit 03 may include a plurality of cascaded shift register units 031. At least two cascaded shift register units 031 may be disposed between two adjacent rows of pixels 02.

For example, referring to FIG. 6, because each two adjacent pixels 02 in the same column share the same light emitting control circuit 021, additional regions are reserved between each two adjacent rows of pixels 02, such as region 1, region 2, region 3, and region 4 shown in FIG. 6. Correspondingly, at least two cascaded shift register units 031 may be disposed in regions 1 to 4 between each two adjacent rows of pixels 02.

Furthermore, to facilitate the signal trace, in combination with FIG. 6, at least two cascaded shift register units 031 may be disposed between two adjacent rows of target pixels 02. In the two rows of target pixels 02, the light emitting control circuit connected to one row of target pixels 02 is different from the light emitting control circuit connected to the other row of target pixels 02. That is, at least two cascaded shift register units 031 may be disposed between two rows of pixels 02 that do not share light emitting control circuits 021.

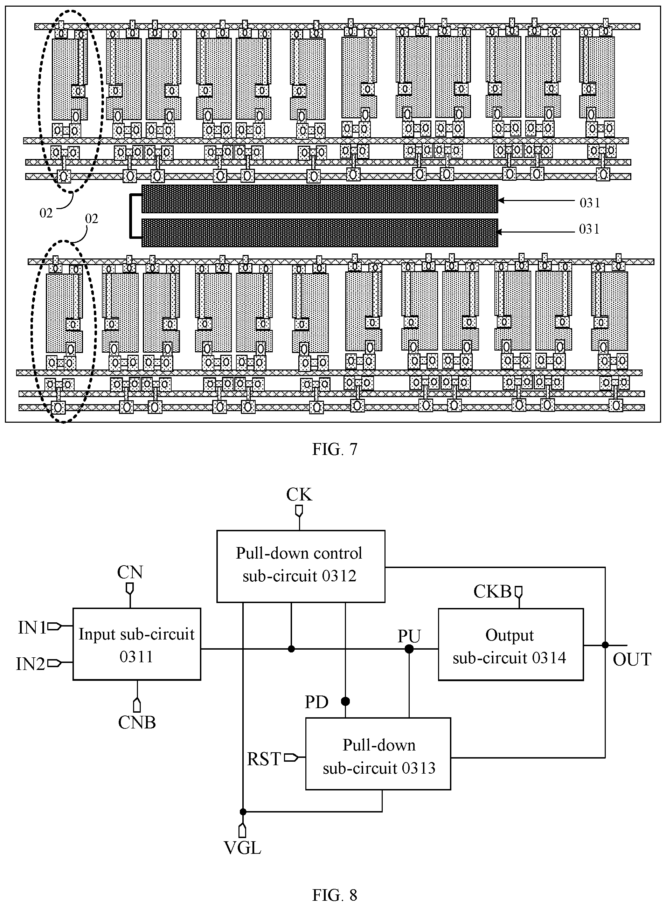

FIG. 7 is a schematic structural diagram of yet another display substrate according to an embodiment of the present disclosure. As shown in FIG. 7, only two cascaded shift register units 031 may be disposed between each two adjacent rows of target pixels 02. One shift register unit 031 may be connected to one row of target pixels 02, and the other shift register unit 031 may be connected to the other row of target pixels 02 (not shown in FIG. 7).

Optionally, the two cascaded shift register units 031 may be symmetrically arranged between the two rows of target pixels. That is, the transistors in one shift register unit 031 are disposed symmetrically with the transistors in the other shift register unit 031. As such, some drive signal lines (e.g., a power signal providing a DC signal) may be shared, thereby further optimizing the GIA space, that is, reducing the area, occupied by the shift register units 031, of the base substrate 01.

FIG. 8 is a schematic structural diagram of a shift register unit according to an embodiment of the present disclosure. As shown in FIG. 8, the shift register unit 031 may include an input sub-circuit 0311, a pull-down control sub-circuit 0312, a pull-down sub-circuit 0313, and an output sub-circuit 0314.

The input sub-circuit 0311 may be connected to a first input terminal IN1, a second input terminal IN2, a first control signal terminal CN, a second control signal terminal CNB, and a pull-up node PU. The input sub-circuit 0311 may be configured to output, in response to a first input signal provided by the first input terminal IN1, a first control signal provided by the first control signal terminal CN to the pull-up node PU, and output, in response to a second input signal provided by the second input terminal IN2, a second control signal provided by the second control signal terminal CNB to the pull-up node PU.

For example, the input sub-circuit 0311 may output the first control signal provided by the first control signal terminal CN to the pull-up node PU when a potential of the first input signal provided by the first input terminal IN1 is a first potential, and output the second control signal provided by the second control signal terminal CNB to the pull-up node PU when a potential of the second input signal provided by the second input terminal IN2 is the first potential.

Optionally, the first input terminal IN1 may be connected to an output terminal of the previous stage of shift register unit 031, and the second input terminal IN2 may be connected to an output terminal of the next stage of shift register unit 031. A potential of the first control signal and a potential of the second control signal may be complementary. That is, the potential of the second control signal is the second potential when the potential of the first control signal is the first potential, and the potential of the second control signal is the first potential when the potential of the first control signal is the second potential. The first potential may be an effective potential, and the second potential may be an ineffective potential. In the case that the transistor is an N-type transistor, the first potential may be a high potential relative to the second potential; and in the case that the transistor is a P-type transistor, the first potential may be a low potential relative to the second potential.

Additionally, for the first stage of shift register unit 031, the previous stage of shift register unit 031 is not present, and for the last stage of shift register unit 031, the next stage of shift register unit 031 is not present. Therefore, in order to ensure normal operation of the gate drive circuit 03, the first stage of shift register unit 031 and the last stage of shift register unit 031 may be connected to an initial signal terminal. The initial signal terminal may be configured to provide an initial signal at the first potential for the first input terminal IN1 connected to the first stage of shift register unit 031, and provide an initial signal at the first potential for the second input terminal IN2 connected to the last stage of shift register unit 031, thereby ensuring normal operation of the first stage of shift register unit 031 and the last stage of shift register unit 031.

The pull-down control sub-circuit 0312 may be connected to a first clock signal terminal CK, the pull-up node PU, a pull-down power terminal VGL, a pull-down node PD, and an output terminal OUT. The pull-down control sub-circuit 0312 may be configured to output, in response to a first clock signal provided by the first clock signal terminal CK, the first clock signal to the pull-down node PD, and output, in response to a potential of the pull-up node PU and an output signal provided by the output terminal OUT, a pull-down power signal provided by the pull-down power terminal VGL to the pull-down node PD.

For example, the pull-down control sub-circuit 0312 may output a first clock signal to the pull-down node PD when a potential of the first clock signal provided by the first clock signal terminal CK is the first potential, to charge the pull-down node PD. The pull-down control sub-circuit 0312 may output the pull-down power signal provided by the pull-down power terminal VGL to the pull-down node PD when a potential of the pull-up node PU is the first potential. The potential of the pull-down power signal may be the second potential, to denoise the pull-down node PD. The pull-down control sub-circuit 0312 may output the pull-down power signal to the pull-down node PD when the potential of the output signal provided by the output terminal OUT is the first potential, to denoise the pull-down node PD.

The pull-down sub-circuit 0313 may be connected to a reset signal terminal RST, the pull-down node PD, the pull-down power terminal VGL, the pull-up node PU, and the output terminal OUT. The pull-down sub-circuit 0313 may be configured to output, in response to the potential of the pull-down node PD, the pull-down power signal to the pull-up node PU and the output terminal OUT, and output, in response to a reset signal provided by the reset signal terminal RST, the pull-down power signal to the pull-up node PU.

For example, the pull-down sub-circuit 0313 may output the pull-down power signal to the pull-up node PU and the output terminal OUT when the potential of the pull-down node PD is the first potential to denoise the pull-up node PU and the output terminal OUT, and output the pull-down power signal to the pull-up node PU when the potential of the reset signal provided by the reset signal terminal RST is the first potential to denoise the pull-up node PU.

The output sub-circuit 0314 may be connected to the pull-up node PU, a second clock signal terminal CKB, and the output terminal OUT. The output sub-circuit 0314 may be configured to output, in response to the potential of the pull-up node PU, a second clock signal provided by the second clock signal terminal CKB to the output terminal OUT.

For example, the output sub-circuit 0314 may output the second clock signal provided by the second clock signal terminal CKB to the output OUT when the potential of the pull-up node PU is the first potential. The second clock signal may be provided for the gate line as a gate drive signal, or provided for the light emitting control line as a light emitting control signal.

FIG. 9 is a schematic structural diagram of another shift register unit according to an embodiment of the present disclosure. As shown in FIG. 9, the input sub-circuit 0311 may include a first input transistor M1 and a second input transistor M2. The pull-down control sub-circuit 0312 may include a first pull-down control transistor M3, a second pull-down control transistor M4, and a third pull-down control transistor M5. The pull-down sub-circuit 0313 may include a first pull-down transistor M6, a second pull-down transistor M7, a third pull-down transistor M8, and a pull-down capacitor C2. The output sub-circuit 0314 may include an output transistor M9 and an output capacitor C3.

A gate of the first input transistor M1 may be connected to the first input terminal IN1, a first electrode of the first input transistor M1 may be connected to the first control signal terminal CN, and a second electrode of the first input transistor M1 may be connected to the pull-up node PU. Correspondingly, the first input transistor M1 may output the first control signal provided by the first control signal terminal CN to the pull-up node PU when the potential of the first input signal provided by the first input terminal IN1 is the first potential to charge the pull-up node PU.

A gate of the second input transistor M2 may be connected to the second input terminal IN2, a first electrode of the second input transistor M2 may be connected to the second control signal terminal CNB, and a second electrode of the second input transistor M2 may be connected to the pull-up node PU. Correspondingly, the second input transistor M2 may output the second control signal provided by the second control signal terminal CNB to the pull-up node PU when the potential of the second input signal provided by the second input terminal IN2 is the first potential to reset the pull-up node PU.

Both a gate and a first electrode of the first pull-down control transistor M3 may be connected to the first clock signal terminal CK, and a second electrode of the first pull-down control transistor M3 may be connected to the pull-down node PD. Correspondingly, the first pull-down control transistor M3 may output the first clock signal to the pull-down node PD when the potential of the first clock signal provided by the first clock signal terminal CK is the first potential to charge the pull-down node PD.

A gate of the second pull-down control transistor M4 may be connected to the pull-up node PU, a first electrode of the second pull-down control transistor M4 may be connected to the pull-down power terminal VGL, and a second electrode of the second pull-down control transistor M4 may be connected to the pull-down node PD. Correspondingly, the second pull-down control transistor M4 may output the pull-down power signal to the pull-down node PD when the potential of the pull-up node PU is the first potential to denoise the pull-down node PD.

A gate of the third pull-down control transistor M5 may be connected to the output terminal OUT, a first electrode of the third pull-down control transistor M5 may be connected to the pull-down power terminal VGL, and a second electrode of the third pull-down control transistor M5 may be connected to the pull-down node PD. Correspondingly, the third pull-down control transistor M5 may output the pull-down power signal to the pull-down node PD when the potential of the output signal provided by the output terminal OUT is the first potential to denoise the pull-down node PD.

A gate of the first pull-down transistor M6 may be connected to the reset signal terminal RST, a first electrode of the first pull-down transistor M6 may be connected to the pull-down power terminal VGL, and a second electrode of the first pull-down transistor M6 may be connected to the pull-up node PU. Correspondingly, the first pull-down transistor M6 may output the pull-down power signal provided by the pull-down power terminal VGL to the pull-up node PU when the potential of the reset signal provided by the reset signal terminal RST is the first potential to denoise the pull-up node PU.

Both a gate of the second pull-down transistor M7 and a gate of the third pull-down transistor M8 may be connected to the pull-down node PD, both a first electrode of the second pull-down transistor M7 and a first electrode of the third pull-down transistor M8 may be connected to the pull-down power terminal VGL, a second electrode of the second pull-down transistor M7 may be connected to the pull-up node PU, and a second electrode of the third pull-down transistor M8 may be connected to the output terminal OUT. Correspondingly, the second pull-down transistor M7 may output the pull-down power signal to the pull-up node PU when the potential of the pull-down node PD is the first potential to denoise the pull-up node PU. The third pull-down transistor M8 may output the pull-down power signal to the output terminal OUT when the potential of the pull-down node PD is the first potential to denoise the output terminal OUT.

One end of the pull-down capacitor C2 may be connected to the pull-down node PD, and another end of the pull-down capacitor C2 may be connected to the pull-down power terminal VGL. The pull-down capacitance C2 may be configured to keep the potential of the pull-down node PD.

One end of the output capacitor C3 may be connected to the pull-up node PU, and another end of the output capacitor C3may be connected to the output terminal OUT. The output capacitor C3 may be configured to keep the potential of the pull-up node PU.

A gate of the output transistor M9 may be connected to the pull-up node PU, a first electrode of the output transistor M9 may be connected to the second clock signal terminal CKB, and a second electrode of the output transistor M9 may be connected to the output terminal OUT.

Correspondingly, for the gate drive circuit 03 to which the shift register unit 031 shown in FIGS. 7 and 8 belongs, the drive signal line connected to the gate drive circuit 03 includes the signal line connected to the first control signal terminal CN, the signal line connected to the second control signal terminal CNB, the signal line connected to the reset signal terminal RST, the signal line connected to the first clock signal terminal CK, the signal line connected to the second clock signal terminal CKB, the signal line connected to the pull-down power terminal VGL, and the signal line connected to the initial signal terminal. In conjunction with the description of the embodiment of FIG. 8, the initial signal terminal is connected to the first input terminal IN1 connected to the first stage of shift register unit 031 and the second input terminal IN2 connected to the last stage of shift register unit 031. As such, in the case that the two shift register units 031 are symmetrically arranged between two rows of target pixels 02, the two shift register units 031 may share one signal line connected to the pull down power terminal VGL.

Referring to FIG. 10, FIG. 10 shows a circuit structure of the shift register unit 031 disposed between two adjacent rows of pixels 02, and an optional position of the drive signal line (e.g., the signal line STV connected to the initial signal terminal) according to the shift register unit 031 shown in FIG. 8. It can be seen in combination with FIG. 6 to FIG. 9 that, in the layout process, the relatively large-sized transistor in the shift register unit 031 may be disposed in region 1 and region 2 with a relatively big area, and the relatively small-sized transistor in the shift register unit 031 may be disposed in region 3 and region 4 with a relatively small area. Referring to FIG. 10, two transistors (e.g., two transistors M7 shown in FIG. 10) may further be connected in series to form one transistor, or two capacitors (e.g., two capacitors C2, or two capacitors C3 shown in FIG. 10) may be connected in series to form one capacitor, such that all transistors in the shift register unit 031 may be reliably disposed within a limited space of the base substrate 01.

In the case that the area of the base substrate 01 is determined, compared with the related art where the light emitting control circuit 021 is not shared, at least two pixels 02 share the same light control circuit 021 in the embodiments of the present disclosure, such that the area of other regions than the region in which the pixels 02 are disposed in the base substrate 01 is larger. Thus, an efficient technical support is provided for disposing the gate drive circuit 03 on the base substrate 01. That is, a technical support is provided for the GIA display substrate with a high resolution (per pixel inch, PPI).

Assuming that the transistors in the pixel 02 are N-type transistors, in combination with the two adjacent pixels 02 sharing the same light control circuit 021 shown in FIG. 4, the operation principle of the pixel provided by the embodiments of the present disclosure is described, and FIG. 11 is a timing diagram of an operation of a pixel according to an embodiment of the present disclosure.

Referring to FIG. 11, in t1 phase, and in the n^{th} row of pixel 02, the second gate line G2n connected to the reset transistor T3 provides the gate drive signal at the first potential, and the reset transistor T3 is turned on. The third gate line G3n connected to the compensation transistor T5 also provides the gate drive signal at the first potential, and the compensation transistor T5 is turned on. Correspondingly, the first initial signal terminal Vin1 may output a first initial signal at the second potential to the second electrode of the drive transistor T4 in the n^{th} row of pixel 02 by the reset transistor T3, to reset the second electrode of the drive transistor T4. The second initial signal terminal Vin2 may output a second initial signal to the gate of the drive transistor T4 in the n^{th} row of pixel 02 by the compensation transistor T5, and the second initial signal may act as compensation data Vref1. The t1 phase may also be referred to as a reset phase during driving of the n^{th} row of pixel 02.

In t2 phase, and in the n^{th} row of pixel 02, the third gate line G3n connected to the compensation transistor T5 continuously provides the gate drive signal at the first potential. The compensation transistor T5 keeps being turned on. The second initial signal terminal Vin2 may continue outputting the second initial signal to the gate of the drive transistor T4 in the n^{th} row of pixel 02 by the compensation transistor T5. Under the coupling effect of the storage capacitor C1, the potential of the gate of the drive transistor T4 may change with the potential of the second electrode of the drive transistor T4, until to Vref1-Vth1, and Vth1 is a threshold voltage of the drive transistor T4. The t2 phase may be referred to as a compensation phase during driving of the n^{th} row of pixel 02.

In t3 phase, and in the n^{th} row of pixel 02, the first gate line G1n connected to the data write transistor T2 begins to provide the gate drive signal at the first potential, and the data write transistor T2 is turned on. The data line D1 outputs a data signal to the gate of the drive transistor T4 by the data write transistor T2. The t3 phase may be referred to as a data write phase during driving of the n^{th} row of pixel 02.

In t4 phase, and in the n^{th} row of pixel 02, the second gate line G2(n+1) connected to the reset transistor T3 provides the gate drive signal at the first potential, and the reset transistor T3 is turned on. The third gate line G3(n+1) connected to the compensation transistor T5 also provides the gate drive signal at the first potential, and the compensation transistor T5 is turned on. Correspondingly, the first initial signal terminal Vin1 may output the first initial signal at the second potential to the second electrode of the drive transistor T4 in the (n+1)^{th} row of pixel 02 by the reset transistor T3, thereby resetting the second electrode of the drive transistor T4. The second initial signal terminal Vin2 may output the second initial signal to the gate of the drive transistor T4 in the (n+1)^{th} row of pixels 02 by the compensation transistor T5, and the second initial signal may act as compensation data Vref2 during driving of this row of pixel. The t4 phase may be referred to as a reset phase during driving of the (n+1)^{th} row of pixel 02.

In t5 phase, and in the (n+1)^{th} row of pixel 02, the third gate line G3(n+1) connected to the compensation transistor T5 continuously provides the gate drive signal at the first potential. The compensation transistor T5 keeps being turned on. The second initial signal terminal Vin2 may continue outputting the second initial signal to the gate of the drive transistor T4 in the (n+1)^{th} row of pixel 02 by the compensation transistor T5. Under the coupling effect of the storage capacitor C1 in this row of pixel 02, the potential of the gate of the drive transistor T4 in the row of pixels 02 may change with the potential of the second electrode of the drive transistor T4, until to Vref2-Vth2, and Vth2 is the threshold voltage of the drive transistor T4. The t5 phase may be referred to as a compensation phase during driving of the (n+1)^{th} row of pixel 02.

In t6 phase, and in the (n+1)^{th} row of pixel 02, the first gate line G1(n+1) connected to the data write transistor T2 begins to provide the gate drive signal at the first potential, and the data write transistor T2 is turned on. The data line D1 may output a data signal to the gate of the drive transistor T4 in this row of pixel 02 by the data write transistor T2. The t6 phase may be referred to as a data write phase during driving of the (n+1)^{th} row of pixel 02.

It should be noted that referring to FIG. 10, the light emitting control line EMn connected to the light emitting control transistor T1 shared by the n^{th} row of pixel 02 and the (n+1)^{th} row of pixel 02 continuously provides the light emitting control signal at the first potential in phase t1, phase t2, phase t4, and phase t5. The DC power terminal VDD may output a DC power signal to the first electrodes of the drive transistors T4 in the two rows of pixels 02 by the light emitting control transistor T1. After the t3 phase, in the n^{th} row of pixel 02, the drive transistor T4 may output, based on the DC power signal and the data signal, the drive signal to the connected light emitting element 023 to drive the n^{th} row of light emitting element 023 to emit light. After the t6 phase, in the (n+1)^{th} row of pixel 02, the drive transistor T4 may output, based on the DC power signal and the data signal, the drive signal to the connected light emitting element 023 to drive the (n+1)^{th} row of light emitting element 023 to emit light.

Because in the display substrate, at least two pixels disposed on the base substrate may share the same light emitting control circuit connected to the light emitting control line, the number of light emitting control circuits required to be set in the display substrate may be reduced, or the number of light emitting control lines required to be set in the display substrate may be further reduced. That is, the area, occupied by each pixel, of the base substrate is smaller. Therefore, both the gate drive circuit that provides the signal for the signal line connected to the pixels, and the drive signal connected to the gate drive circuit can be disposed on the base substrate. The display substrate provided in the embodiments of the present disclosure has a higher resolution.

FIG. 12 is a schematic structural diagram of a display device according to an embodiment of the present disclosure. As shown in FIG. 12, the display device may include a source drive circuit 100 and a display substrate 000 shown in any of FIGS. 1 to 3, 6, 7 and 10.

The source drive circuit 100 may be connected to a plurality of data lines D1 to Dm in the display substrate 000, and may be configured to provide a data signal to each of the data lines.

FIG. 12 further shows a gate drive circuit 03, a plurality of first gate lines from G11 to G1m, a plurality of second gate lines from G21 to G2m, a plurality of third gate lines from G3 to G3m, and a plurality of light emitting control lines from EM1 to EMn that are included in the display substrate 000. The gate drive circuit 03 may be connected to the plurality of gate lines G1, the plurality of first gate lines from G11 to G1m, the plurality of second gate lines from G21 to G2m, the plurality of third gate lines from G3 to G3m, and the plurality of light emitting control lines from EM1 to EMn. The gate drive circuit 03 may be configured to provide a gate drive signal for the plurality of first gate lines from G11 to G1m, the plurality of second gate lines from G21 to G2m, and the plurality of third gate lines from G3 to G3m, and provide a light emitting control drive signal for the plurality of light emitting control lines from EM1 to EMn.

Optionally, in the embodiment of the present disclosure, to achieve a reliable supply of the drive signal to the plurality of first gate lines from G11 to G1m, the plurality of second gate lines from G21 to G2m, the plurality of third gate lines from G3 to G3m, and the plurality of light emitting control lines from EM1 to EMn, the gate drive circuit 03 may include four gate drive circuits, i.e., a gate drive circuit configured to provide the gate drive signal for the first gate lines, a gate drive circuit configured to provide the gate drive signal for the second gate lines, a gate drive circuit configured to provide the gate drive signal for the third gate lines, and a gate drive circuit configured to provide the light emitting control drive signal for the light emitting control lines. In combination with FIG. 7, each gate drive circuit may be composed of at least two cascaded shift register units 031, and each shift register unit 031 may be connected to one corresponding signal line (e.g., the first gate line).

Optionally, the display device may be an OLED display device, an electronic paper, a mobile phone, a tablet computer, a television, a display, a laptop computer, a digital photo frame, or any product or component having a display function.

It should be understood that the term "a plurality of" referred herein means two or more. The above description is merely optional embodiments of the present disclosure, and is not intended to limit the present disclosure. Any modifications, equivalent substitutes, improvements made within the spirit and scope of the present disclosure should fall within the scope of protection of the present disclosure.

## Claims

1. A display substrate, comprising:
a base substrate;
a plurality of pixels arranged in an array on the base substrate, wherein each of the pixels comprises: a light emitting control circuit, a light emitting drive circuit, and a light emitting element, and at least two of the pixels share a same light emitting control circuit; and
a gate drive circuit, a plurality of light emitting control lines, a plurality of gate lines, and a plurality of drive signal lines that are disposed on the base substrate, wherein the gate drive circuit is connected to the plurality of drive signal lines, the plurality of light emitting control lines, and the plurality of gate lines, the plurality of light emitting control lines are connected to the light emitting control circuits in the plurality of pixels, the plurality of gate lines are connected to the light emitting drive circuits in the plurality of pixels, and the gate drive circuit is configured to output, in response to a drive signal provided by the plurality of drive signal lines, a light emitting control signal to the plurality of light emitting control lines, and a gate drive signal to the plurality of gate lines.

2. The display substrate according to claim 1, wherein the at least two of the pixels sharing the same light emitting control circuit are disposed in a same column.

3. The display substrate according to claim 2, wherein the at least two of the pixels sharing the same light emitting control circuit are adjacent.

4. The display substrate according to claim 3, wherein each two of the pixels in the same column share a same light emitting control circuit.

5. The display substrate according to claim 4, wherein the two of the pixels sharing the same light emitting control circuit are symmetrically arranged on two sides of the light emitting control line connected to the light emitting control circuit.

6. The display substrate according to any of claims 1 to 5, wherein each of the drive signal lines is disposed between two adjacent columns of the pixels.

7. The display substrate according to claim 6, wherein at most two of the drive signal lines are disposed between each two adjacent columns of the pixels.

8. The display substrate according to any of claims 1 to 7, wherein the gate drive circuit comprises: a plurality of cascaded shift register units,
wherein at least two of the cascaded shift register units are disposed between two adjacent rows of the pixels.

9. The display substrate according to claim 8, wherein at least two of the cascaded shift register units are disposed between two adjacent rows of target pixels,
wherein in the two rows of target pixels, the light emitting control circuit connected to one row of target pixels is different from the light emitting control circuit connected to the other row of target pixels.

10. The display substrate according to claim 9, wherein two cascaded shift register units are disposed between each two adjacent rows of target pixels,
wherein one of the shift register units is connected to one row of target pixels, and the other one of the shift register units is connected to the other row of target pixels.

11. The display substrate according to claim 10, wherein the two cascaded shift register units are symmetrically disposed between the two rows of target pixels.

12. The display substrate according to claim 8, wherein the shift register unit comprises: an input sub-circuit, a pull-down control sub-circuit, a pull-down sub-circuit, and an output sub-circuit, wherein
the input sub-circuit is connected to a first input terminal, a second input terminal, a first control signal terminal, a second control signal terminal, and a pull-up node, and the input sub-circuit is configured to output, in response to a first input signal provided by the first input terminal, a first control signal provided by the first control signal terminal to the pull-up node, and output, in response to a second input signal provided by the second input terminal, a second control signal provided by the second control signal terminal to the pull-up node;
the pull-down control sub-circuit is connected to a first clock signal terminal, the pull-up node, a pull-down power terminal, a pull-down node, and an output terminal, and the pull-down control sub-circuit is configured to output, in response to a first clock signal provided by the first clock signal terminal, the first clock signal to the pull-down node, and output, in response to a potential of the pull-up node and an output signal provided by the output terminal, a pull-down power signal provided by the pull-down power terminal to the pull-down node;
the pull-down sub-circuit is connected to a reset signal terminal, the pull-down node, the pull-down power terminal, the pull-up node, and the output terminal, and the pull-down sub-circuit is configured to output, in response to a potential of the pull-down node, the pull-down power signal to the pull-up node and the output terminal, and output, in response to a reset signal provided by the reset signal terminal, the pull-down power signal to the pull-up node; and
the output sub-circuit is connected to the pull-up node, a second clock signal terminal, and the output terminal, and the output sub-circuit is configured to output, in response to the potential of the pull-up node, a second clock signal provided by the second clock signal terminal to the output terminal.

13. The display substrate according to any of claims 1 to 12, further comprising: a plurality of data lines disposed on the base substrate;
wherein the plurality of gate lines comprises a plurality of first gate lines, a plurality of second gate lines, and a plurality of third gate lines; the light emitting control circuit comprises a light emitting control transistor; and the light emitting drive circuit comprises a data write transistor, a reset transistor, a drive transistor, a compensation transistor, and a storage capacitor, wherein
a gate of the data write transistor is connected to one of the first gate lines, a first electrode of the data write transistor is connected to a gate of the drive transistor, and a second electrode of the data write transistor is connected to one of the of data lines;
a first electrode of the drive transistor is connected to a first electrode of the light emitting control transistor, and a second electrode of the drive transistor is connected to the light emitting element;
a gate of the light emitting control transistor is connected to one of the light emitting control lines, and a second electrode of the light emitting control transistor is connected to a DC power terminal;
a gate of the reset transistor is connected to one of the second gate lines, a first electrode of the reset transistor is connected to a first initial signal terminal, and a second electrode of the reset transistor is connected to the second electrode of the drive transistor; and
a gate of the compensation transistor is connected to one of the third gate lines, a first electrode of the compensation transistor is connected to a second initial signal terminal, and a second electrode of the compensation transistor is connected to the gate of the drive transistor.

14. The display substrate according to claim 12, wherein each of the drive signal lines is disposed between two adjacent columns of the pixels, and at most two of the drive signal lines are disposed between each two adjacent columns of the pixels;
wherein two cascaded shift register units are disposed between each two adjacent rows of target pixels, and the two cascaded shift register units are symmetrically disposed between the two rows of target pixels, one of the shift register units being connected to one row of target pixels, and the other one of the shift register units being connected to the other row of target pixels; and in the two rows of target pixels, the light emitting control circuit connected to one row of target pixels is different from the light emitting control circuit connected to the other row of target pixels;
the display substrate further comprises: a plurality of data lines disposed on the base substrate; the plurality of gate lines comprises a plurality of first gate lines, a plurality of second gate lines, and a plurality of third gate lines; the light emitting control circuit comprises a light emitting control transistor; and the light emitting drive circuit comprises a data write transistor, a reset transistor, a drive transistor, a compensation transistor, and a storage capacitor, wherein
a gate of the data write transistor is connected to one of the first gate lines, a first electrode of the data write transistor is connected to a gate of the drive transistor, and a second electrode of the data write transistor is connected to one of the data lines;
a first electrode of the drive transistor is connected to a first electrode of the light emitting control transistor, and a second electrode of the drive transistor is connected to the light emitting element;
a gate of the light emitting control transistor is connected to one of the light emitting control lines, and a second electrode of the light emitting control transistor is connected to a DC power terminal;
a gate of the reset transistor is connected to one of the second gate lines, a first electrode of the reset transistor is connected to a first initial signal terminal, and a second electrode of the reset transistor is connected to the second electrode of the drive transistor; and
a gate of the compensation transistor is connected to one of the third gate lines, a first electrode of the compensation transistor is connected to a second initial signal terminal, and a second electrode of the compensation transistor is connected to the gate of the drive transistor.

15. A display device, comprising a source drive circuit and the display substrate according to any of claims 1 to 14,
wherein the source drive circuit is connected to the plurality of data lines in the display substrate, and the source drive circuit is configured to provide a data signal for the data lines.
